# EUROPEAN PATENT SPECIFICATION

(11) **EP 4 571 577 B1**
(45) Date of publication and mention of the grant of the patent: **09.12.2026**
(21) Application number: 25165178.2
(22) Date of filing: 11.02.2019
(51) Int. Cl.: G06N 3/0442, G06N 3/045, G06N 3/0475

(54) **GENERATING OUTPUT EXAMPLES USING RECURRENT NEURAL NETWORKS CONDITIONED ON BIT VALUES**
ERZEUGUNG VON AUSGABEBEISPIELEN UNTER VERWENDUNG REKURRENTER NEURONALER NETZE, DIE AUF BITWERTEN KONDITIONIERT SIND
GÉNÉRATION D'EXEMPLES DE SORTIE À L'AIDE DE RÉSEAUX NEURONAUX RÉCURRENTS CONDITIONNÉS SUR DES VALEURS DE BITS

(30) Priority: 09.02.2018 US 201862628913 P
(43) Date of publication of application: 18.06.2025
(62) Document number(s) of the earlier application(s) in accordance with Art. 76 EPC: 19704794.7 / 3 698 292
(73) Proprietor: GDM Holding LLC, Mountain View, CA 94043 (US)
(72) Inventor: KALCHBRENNER, Nal Emmerich, London, N1C 4AG (GB); SIMONYAN, Karen, London, N1C 4AG (GB); ELSEN, Erich Konrad, Mountain View, 94043 (US)
(74) Representative: Marks & Clerk GST

(56) References cited:
- SOROUSH MEHRI ET AL: "SampleRNN: An Unconditional End-to-End Neural Audio Generation Model", 11 February 2017 (2017-02-11), XP055584855, Retrieved from the Internet <URL:https://arxiv.org/pdf/1612.07837.pdf> [retrieved on 20190430]

## Description

### BACKGROUND

This specification relates to generating output examples using neural networks.

Neural networks are machine learning models that employ one or more layers of nonlinear units to predict an output for a received input. Some neural networks include one or more hidden layers in addition to an output layer. The output of each hidden layer is used as input to the next layer in the network, i.e., the next hidden layer or the output layer. Each layer of the network generates an output from a received input in accordance with current values of a respective set of parameters.

Some neural networks are recurrent neural networks. A recurrent neural network is a neural network that receives an input sequence and generates an output sequence from the input sequence. In particular, a recurrent neural network can use some or all of the internal state of the network from a previous time step in computing an output at a current time step.

An example of a recurrent neural network is a Long Short-Term Memory (LSTM) neural network that includes one or more LSTM memory blocks. Each LSTM memory block can include one or more cells that each include an input gate, a forget gate, and an output gate that allow the cell to store previous states for the cell, e.g., for use in generating a current activation or to be provided to other components of the LSTM neural network. Mehri et al., "SampleRNN: An Unconditional End-to-End Neural Audio Generation Model", arXiv:1612.07837, describes a computationally efficient approach to unconditional generation of audio with recurrent neural networks involving modules operating at different clock rates, the lowest module processing individual samples.

### SUMMARY

The invention is set out in the independent claims.

Particular embodiments of the subject matter described in this specification can be implemented so as to realize one or more of the following advantages.

By first generating the values for the first half of the N bits, e.g., the most significant bits, and then generating the values for the second half of the N bits, e.g., the least significant bits, conditioned on the values of the first half, the system improves the accuracy of the outputs generated. Moreover, the network can achieve this improved accuracy while being computationally compact. In particular, because the neural network includes only a single recurrent layer (and output layers that have relatively low computational cost) to operate on a conditioning input, the network can generate high-quality outputs quicker than conventional approaches. This may allow the network to be used in environments where outputs need to be generated in real-time, e.g., when deployed on a mobile device or another user device.

Additionally, the system can generate two outputs per time step without needing to re-compute computationally expensive matrix multiplies, i.e., by only computing the recurrent contribution to the updated hidden state once, minimizing the additional computation and processing power required to generate the second output.

Moreover, by generating separate score distributions over the first half of the bits and second half of the bits, the system reduces the output space, allowing for efficient prediction of multi-bit values. As a particular example, when N is 16, i.e., all of the values are 16-bit values, the neural network only requires two relatively small output spaces (two score distributions of 2^8 scores each) instead of one large output space (with each time step needing to have a score distribution that has 2^16 scores), reducing the amount of computation required to effectively predict 16-bit values.

The architecture of the network lends itself well to being optimized on a GPU or other special-purpose hardware, resulting in additional computational and time savings. For example, in implementations the network has only a single recurrent layer, and the size of the hidden state of the recurrent layer, i.e., the number of units in the hidden state, can be readily configured to optimize for the memory available on the special-purpose hardware.

The details of one or more embodiments of the subject matter described in this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 shows an example neural network system.
FIG. 2 is a diagram showing the processing performed by the recurrent neural network to generate an output value at a generation time step.
FIG. 3 is a flow diagram of an example process for generating an output example.

Like reference numbers and designations in the various drawings indicate like elements.

### DETAILED DESCRIPTION

This specification describes a system implemented as computer programs on one or more computers in one or more locations that generates output examples using a recurrent neural network. Each output example includes a respective output value at each of multiple generation time steps. In some cases, the system can generate the output example by conditioning the recurrent neural network on a conditioning input.

In some cases the system generates audio data and at each generation time step the output value may be e.g. a time-domain or frequency audio data value for defining an audio waveform. For example, the system can be part of a system that converts text to speech. In this example, the output example is a sequence of audio data, e.g., a waveform, that represents an utterance of a piece of text and the recurrent neural network is conditioned on a sequence of linguistic features of the piece of text. That is, at each generation time step, the conditioning input is a set of linguistic features and the output value is a value that defines the amplitude of the waveform. In some implementations, the audio value at each generation time step in the sequence is the amplitude of the audio waveform at the corresponding time, i.e., the output example is a raw audio waveform. In other implementations, the audio value at each generation time step in the sequence is a compressed or companded representation of the waveform at the corresponding time. For example, the audio value can be a µ-law transformed representation of the waveform. In other implementations the audio value at a time step may be for a STFT (short-time Fourier transform) representation of the audio waveform.

As another example, the system can generate image data for a still or moving image, e.g., conditioned on a caption or not conditioned on any explicit input. At each generation time step, the output value is a pixel value, e.g., a color value, i.e., an intensity value, for some color channel of some pixel of the image.

As another example, the system can be part of a speech recognition system. In this example, the output example is a sequence of text that represents a transcription of an utterance and the recurrent neural network is conditioned on a sequence of raw audio of the utterance or audio features of the utterance. That is, at each generation time step, the output value is data that identifies some unit of text, e.g., a word, a character, or a grapheme.

In particular, each output value in the output example is an N-bit value, e.g., a 4-bit value, 8-bit value, 16-bit value, or 24-bit value. That is, each output value in the output example 162 is represented as a sequence of *N* bits. For example, when the output example is a speech waveform, the output example can be an ordered, i.e., by time, collection of *N*-bit amplitude values or *N*-bit compressed or companded amplitude values.

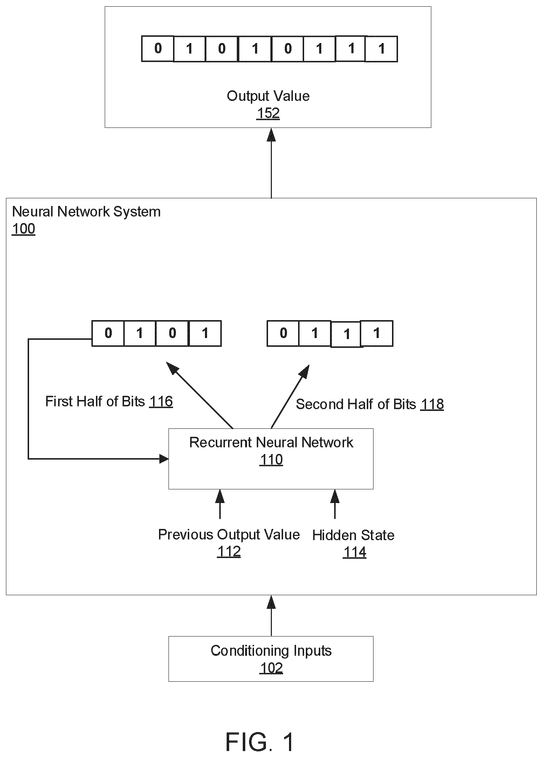

FIG. 1 shows an example neural network system 100. The neural network system 100 is an example of a system implemented as computer programs on one or more computers in one or more locations, in which the systems, components, and techniques described below can be implemented.

The neural network system 100 generates an output example that includes multiple output values 152 by generating at least one output value 152 at each of multiple generation time steps. As described above, each output value is an N-bit value and is represented as a sequence of N bits. In the example of FIG. 1, the output value 152 is an 8-bit value, i.e., represented by the sequence of bits [0, 1, 0, 1, 0, 1, 1, 1].

At a given generation time step, the system 100 processes a first recurrent input that includes the previous output value 112, i.e., the N-bit output value at the preceding generation time step in the sequence, using a recurrent neural network 110 and in accordance with a hidden state 114 of the recurrent neural network 110 to generate a first score distribution over possible values for a first half of the N bits in the output value at the generation time step. If the output is conditioned on some external conditioning input, the first recurrent input also includes a conditioning input 102 for the generation time step.

The system 100 then selects, using the first score distribution, values 116 for the first half of the N bits of the output value, e.g., by sampling a sequence of N bits from the possible sequences of N bits in accordance with the score distribution. In the example of FIG. 1, the system 100 has selected the values [0, 1, 0, 1] as the values 116 of the first half of the N bits.

The system 100 then processes a second recurrent input that includes (i) the previous output value 112 and (ii) the values 116 for the first half of the N bits (and, if the output is conditioned on some input, the conditioning input 102 for the generation time step) using the recurrent neural network 110 and in accordance with the same hidden state 114 to generate a second score distribution over possible values for the second half of the N bits in the output value at the generation time step.

The system then selects, using the second score distribution, values 118 for the second half of the N bits of the output value, e.g., by sampling from the second score distribution. For example, the system 100 has selected the values [0, 1, 1, 1] as the values 118 for the second half of the bits, resulting in the output value 152 being represented as [0, 1, 0, 1, 0, 1, 1, 1].

Thus, at a given generation time step, the system first generates the values 116 for the first half of the N bits, i.e., the most significant bits, and then generates the values 118 for the second half of the N bits, i.e., the least significant bits, conditioned on the values of the first half of the N bits.

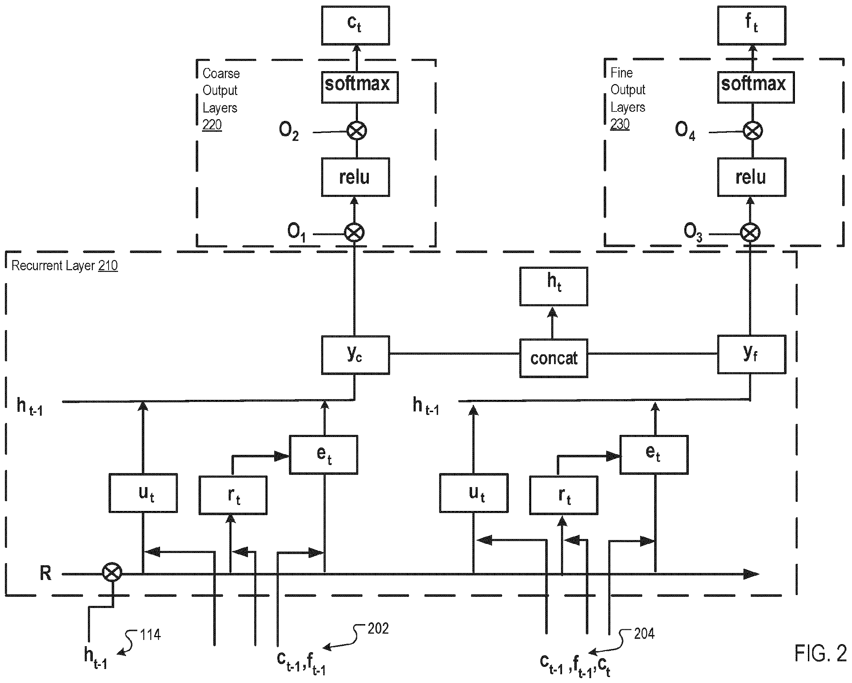

The architecture of the recurrent neural network 110 and the operations performed by the recurrent neural network to generate an output value are described below with reference to FIG. 2.

By generating output examples in this manner and using a recurrent neural network as described in this specification, the system 100 generates accurate outputs with minimal latency and while consuming fewer computational resources. Thus, the system 100 may be implemented, for example, on a mobile device, on a smart speaker, or on another resource-constrained computer that nonetheless requires high-quality output examples to be generated with low latency.

FIG. 2 is a diagram showing the processing performed by the recurrent neural network 110 to generate an output value 152 at a generation time step *t*.

The processing shown in the diagram can be repeated for multiple generation time steps to generate each output value in an output example.

As shown in FIG. 2, the recurrent neural network 110 includes only a single recurrent neural network layer 210, i.e., as opposed to multiple recurrent neural network layers stacked one after the other. The recurrent neural network 110 also includes a set of one or more coarse output layers 220 and a set of one or more fine output layers 230.

Generally, the single recurrent neural network layer 210 maintains a hidden state **h** that is updated at each generation time step. The hidden state is a vector of numeric values.

At generation time step *t*, the recurrent neural network 110 receives a first input 202 that includes the output value generated at the preceding generation time step, i.e., a combination of the values for the first half of bits **c***ₜ₋₁* from the preceding output value and the values of the second half of bits **f***ₜ₋₁* from the preceding output value. For example, the system can encode **c***ₜ₋₁* and **f***ₜ₋₁* as scalars in the range of [0,2^(N/2) - 1] and then scale the scalars to the appropriate interval for processing by the recurrent neural network, e.g., [-1,1].

The recurrent neural network 110 processes the first input 202 in accordance with the hidden state from the previous generation time step **h***ₜ₋₁* to generate a first score distribution over possible values for the first half of the bits. In other words, the score distribution includes a respective score for each possible combination of values for the first half of the *N* bits. For example, when *N* is 16, the score distribution will include a respective score for each of the 2^8 possible combinations of values for the first 8 bits of the output value.

The system then selects the values of the first half of the bits (the "coarse bits") **c***ₜ* using the score distribution, e.g., by sampling from the score distribution or selecting the combination of values with the highest score.

The recurrent neural network 110 then processes a second input 204 that includes the output value generated at the preceding generation time step (**c***ₜ₋₁,* **f***ₜ₋₁*) and the values **c***ₜ* (in accordance with **h***ₜ₋₁*) to generate a second score distribution over possible values for the second half of the bits (the "fine bits"). For example, the system can encode **c***ₜ* in the same manner as **c***ₜ₋₁* and **f***ₜ₋₁* to generate the second input 204. Like the first score distribution, the second score distribution includes a respective score for each possible combination of values for the second half of the *N* bits. The system then selects the second half of the bits **f***ₜ* using the second score distribution.

In particular, the recurrent layer 210 processes the first input 202 in accordance with **h***ₜ₋₁* to generate the first half **y***_{c}* of the updated hidden state **h***ₜ* for the generation time step t.

To generate **y***_{c}*, the recurrent layer 210 determines a respective recurrent contribution for each gate in a set of one or more gates of the recurrent layer 210 by applying a recurrent weight matrix **R** to the hidden state **h***ₜ₋₁.* In other words, the recurrent layer 210 computes a matrix-vector product between **R** and **h***ₜ₋₁* to generate a vector that includes the recurrent contributions for each of the gates, i.e., with different portions of the vector corresponding to different gates.

The recurrent layer 210 then determines, for each gate, a respective input contribution for the gate from the first input 202 and determines the gate vector for the gate from at least the recurrent contribution for the gate and the input contribution for the gate. In the example of FIG. 2, the recurrent layer 210 has three gates u, r, and e and therefore computes three gate vectors **u***ₜ*, **r***ₜ*, and **e***ₜ*. In particular, in the example of FIG. 2, the gate vectors **u***ₜ*, **r***ₜ*, and **e***ₜ* satisfy: ${u}_{t} = σ \left({rc}_{u}+{I}_{u}^{∗}{x}_{t}\right) ,$ ${r}_{t} = σ \left({rc}_{r}+{I}_{r}^{∗}{x}_{t}\right) ,$ and $\left.{e}_{t}=τ\left({r}_{t}∘{rc}_{e}\right)+{I}_{e}^{∗}{x}_{t}\right) ,$ where *σ* is e.g. the sigmoid non-linear function, **rc***ᵤ* is the recurrent contribution for gate u, ${I}_{u}^{∗}$ is an input weight matrix for the gate u that is masked such that **c***ₜ* does not affect the first half of the state **y***_{c}*, **x***ₜ* is an input to the recurrent layer, i.e., either the first input 202 or the second input 204, **rc***ᵣ* is the recurrent contribution for gate r, ${I}_{r}^{∗}$ is an input weight matrix for the gate r that is masked such that **c***ₜ* does not affect the first half of the state **y***_{c}*, *τ* is e.g. the tanh non-linear function, ∘ denotes element-wise multiplication, **rc***ₑ* is the recurrent contribution for gate e, and ${I}_{e}^{∗}$ is an input weight matrix for the gate e that is masked such that **c***ₜ* does not affect the first half of the state **y***_{c}*. In other words, the matrices **I** are masked such that, when **x***ₜ* is the second input 204, the values of **c***ₜ* being missing does not affect the first half of the resulting hidden state **h***ₜ* as shown below. While not shown in the above equations, some or all of the gates can include an addition of one or more bias vectors for the gate as part of the calculation of the gate vector for the gate, i.e., before the application of the non-linearity for the gate.

The recurrent layer 210 then computes **y***_{c}* from **h***ₜ₋₁* and the gate vectors. In the example of Fig. 2, **y***_{c}* is the first half of the temporary hidden state **h***ₜ* that is computed as: ${h}_{t} = {u}_{t} ∘ {h}_{t - 1} + \left(1-{u}_{t}\right) ∘ {e}_{t}$ In other words, the recurrent layer 210 splits **h***ₜ* computed as above into two vectors and uses the first vector as **y***_{c}*.

The set of coarse output layers 220 then processes **y***_{c}* to generate the score distribution over values for the first half of bits.

In particular, in the example of FIG. 2, the coarse output layers 220 are configured to apply a first weight matrix **O***₁* to **y***_{c}* to generate a first projected updated hidden state, apply an element-wise non-linear activation function (e.g., the rectified liner unit ("relu") function) to the first projected updated hidden state to generate a first activation vector, apply a second weight matrix **O**₂ to the first activation vector to generate first logits, and apply a softmax function ("softmax") to the first logits to generate the first score distribution.

Once the system has selected the first half of bits, the recurrent layer 210 processes the second input 204 in accordance with **h***ₜ₋₁* to generate the second half **y***_{f}* of the updated hidden state **h***ₜ*. In particular, the final updated hidden state **h***ₜ* is a concatenation ("concat") of **y***_{c}* and **y***_{f}*. In other words, the final updated hidden state **h***ₜ* can be split into **y***_{c}* and **y***_{f}*.

To generate **y***_{f}*, the recurrent layer 210 re-computes the gate vectors for the set of gates by using the second input 204 instead of the first input 202 and then computes **y***_{f}* from **h***ₜ₋₁* and the re-computed gate vectors. Advantageously, when re-computing the gate vectors for the set of gates, the recurrent layer 210 re-uses and does not re-compute the recurrent contributions to the gates from the processing of the first input 202.

In other words, when determining the gate vectors for the second input 204, the recurrent layer 210 does not re-compute the matrix-vector product between **R** and **h***ₜ₋₁* and only re-computes the input contributions for the respective gates by using the second input 204 as **x***ₜ* in the equations above.

The recurrent layer 210 then computes **y***_{f}* from **h***ₜ₋₁* and the re-computed gate vectors as described above, but with **y***_{f}* being the second half of the updated hidden state **h***ₜ* (and not the first half as described above for computing **y***_{c}*).

The set of fine output layers 230 then processes **y***_{f}* to generate the score distribution over values for the second half of bits.

In particular, in the example of FIG. 2, the fine output layers 230 are configured to apply a weight matrix **O**₃ to **y***_{f}* to generate a second projected updated hidden state, apply an element-wise non-linear activation function (e.g., the rectified liner unit ("relu") function) to the second projected updated hidden state to generate a second activation vector, apply a weight matrix **O***₄* to the second activation vector to generate second logits, and apply a softmax function ("softmax") to the second logits to generate the second score distribution.

Thus, as can be seen from the description of FIG. 2, the recurrent neural network 120 is able to generate the output value at the generation time step by generating two score distributions over small output spaces instead of one score distribution over a large output space. This allows the output value to be generated in a more computationally efficient manner.

As a particular example, when N is 16, i.e., all of the values are 16-bit values, the neural network only requires two relatively small output spaces (two score distributions of 2^8 scores each) instead of one large output space (with each time step needing to have 2^16 scores,), reducing the amount of computation required to effectively predict 16-bit values. In particular, the matrices **O** can be of a much smaller size than the matrices that would be required to project the hidden state **h***ₜ* into a vector having 2^16 values.

Moreover, the recurrent layer 210 computes **y***_{f}* without needing to re-compute the matrix-vector product involving **R,** which is the most computationally-intensive operation performed by the recurrent layer 210, i.e., because the operation involves multiplying a large matrix by a large vector. Thus, only a limited amount of relatively less computationally-intensive operations need to be added in order to allow for generating the output value in two passes at a given time step.

Further, the recurrent neural network 120 includes only a single recurrent layer. Because the recurrent layer has a hidden state that maintains an already compressed representation of the context for a given output value, an RNN is able to combine the context with the input within a single transformation. Thus, the recurrent neural network 120 is able to avoid using a deep and narrow architecture requiring a long chain of layers to be executed for each value and drastically reduces the number of operations that need to be performed at each time step.

When a conditioning input is used to further condition the generation of the output value, both the first input 202 and the second input 204 also include the conditioning input for the generation time step. In particular, the recurrent neural network can process received conditioning features, e.g., linguistic features, through a conditioning neural network that includes one or more neural network layers, e.g., convolutional layers, to generate a conditioning input 208 that is a vector that has the same dimensionality as the hidden state. Each of the gate vectors can then be based on the conditioning input 208. The conditioning input 208 can be applied at any appropriate point before the gate vectors are calculated. In the example shown in FIG. 2, the conditioning input 208 is added to each of the recurrent contributions, i.e. after the matrix-vector product between between **R** and **h***ₜ₋₁* has been computed. This can then be re-used instead of needing to be re-computed when the gate vectors are re-computed.

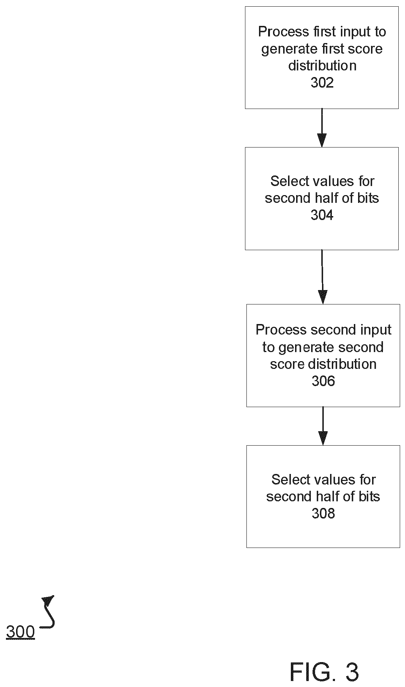

FIG. 3 is a flow diagram of an example process 300 for generating an output value. For convenience, the process 300 will be described as being performed by a system of one or more computers located in one or more locations. For example, a neural network system, e.g., the neural network system 100 of FIG. 1, appropriately programmed, can perform the process 300.

The system can repeat the process 300 at multiple generation time steps to generate an output example that includes multiple N-bit output values.

The system processes a first input to generate a first score distribution (step 302). In particular, the first input includes the preceding output value generated at the preceding time step and, when the output example is conditioned on a conditioning input, a conditioning input for the generation time step.

The system selects values for the first half of the N bits from the first score distribution (step 304), e.g., by sampling from the first score distribution

The system processes a second input to generate a second score distribution (step 306). The second input includes the preceding output value and the values of the first half of bits from the current output value.

The system selects values for the second half of the N bits from the second score distribution (step 308), e.g., by sampling from the second score distribution.

This specification uses the term "configured" in connection with systems and computer program components. For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially generated propagated signal, e.g., a machine-generated electrical, optical, or electromagnetic signal, that is generated to encode information for transmission to suitable receiver apparatus for execution by a data processing apparatus.

The term "data processing apparatus" refers to data processing hardware and encompasses all kinds of apparatus, devices, and machines for processing data, including by way of example a programmable processor, a computer, or multiple processors or computers. The apparatus can also be, or further include, special purpose logic circuitry, e.g., an FPGA (field programmable gate array) or an ASIC (application specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program, which may also be referred to or described as a program, software, a software application, an app, a module, a software module, a script, or code, can be written in any form of programming language, including compiled or interpreted languages, or declarative or procedural languages; and it can be deployed in any form, including as a stand alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub programs, or portions of code. A computer program can be deployed to be executed on one computer or on multiple computers that are located at one site or distributed across multiple sites and interconnected by a data communication network.

In this specification, the term "database" is used broadly to refer to any collection of data: the data does not need to be structured in any particular way, or structured at all, and it can be stored on storage devices in one or more locations. Thus, for example, the index database can include multiple collections of data, each of which may be organized and accessed differently.

Similarly, in this specification the term "engine" is used broadly to refer to a software-based system, subsystem, or process that is programmed to perform one or more specific functions. Generally, an engine will be implemented as one or more software modules or components, installed on one or more computers in one or more locations. In some cases, one or more computers will be dedicated to a particular engine; in other cases, multiple engines can be installed and running on the same computer or computers.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer readable media suitable for storing computer program instructions and data include all forms of non volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser. Also, a computer can interact with a user by sending text messages or other forms of message to a personal device, e.g., a smartphone that is running a messaging application, and receiving responsive messages from the user in return.

Data processing apparatus for implementing machine learning models can also include, for example, special-purpose hardware accelerator units for processing common and compute-intensive parts of machine learning training or production, i.e., inference, workloads.

Machine learning models can be implemented and deployed using a machine learning framework, .e.g., a TensorFlow framework, a Microsoft Cognitive Toolkit framework, an Apache Singa framework, or an Apache MXNet framework.

Embodiments of the subject matter described in this specification can be implemented in a computing system that includes a back end component, e.g., as a data server, or that includes a middleware component, e.g., an application server, or that includes a front end component, e.g., a client computer having a graphical user interface, a web browser, or an app through which a user can interact with an implementation of the subject matter described in this specification, or any combination of one or more such back end, middleware, or front end components. The components of the system can be interconnected by any form or medium of digital data communication, e.g., a communication network. Examples of communication networks include a local area network (LAN) and a wide area network (WAN), e.g., the Internet.

The computing system can include clients and servers. A client and server are generally remote from each other and typically interact through a communication network. The relationship of client and server arises by virtue of computer programs running on the respective computers and having a client-server relationship to each other. In some embodiments, a server transmits data, e.g., an HTML page, to a user device, e.g., for purposes of displaying data to and receiving user input from a user interacting with the device, which acts as a client. Data generated at the user device, e.g., a result of the user interaction, can be received at the server from the device.

## Claims

1. A computer-implemented method of generating an output example comprising a respective *N*-bit output value (152) at each generation time step of a sequence of generation time steps, the method comprising, for each generation time step:
processing a first recurrent input comprising the *N*-bit output value (112; **c***ₜ₋₁,* **f***ₜ₋₁*) at the preceding generation time step in the sequence using a recurrent neural network (110) and in accordance with a hidden state of the recurrent neural network (114; **h***ₜ₋₁*) to generate a first score distribution over possible values for a first half of the *N* bits in the output value at the generation time step;
selecting, using the first score distribution, values for the first half (116; **c***ₜ*) of the N bits of the output value;
processing a second recurrent input comprising (i) the *N*-bit output value (112; ***c***_{*t*-1}*,* **f***ₜ₋₁*) at the preceding generation time step in the sequence and (ii) the values for the first half of the N bits (116; **c***ₜ*) using the recurrent neural network (110) and in accordance with the same hidden state (114; **h***ₜ₋₁*) to generate a second score distribution over possible values for a second half of the *N* bits in the output value at the generation time step; and
selecting, using the second score distribution, values for the second half (118; **f***ₜ*) of the N bits of the output value;
wherein the first half of the N bits are the most significant bits and the second half of the N bits are the least significant bits.

2. The method of claim 1, wherein the output value is conditioned on a respective conditioning input (102) at each of the generation time steps, and wherein the first recurrent input and the second recurrent input each also comprise the conditioning input for the generation time step; the method further comprising:
generating the conditioning input at the generation time step by processing conditioning features using a conditioning neural network.

3. The method of any preceding claim, wherein the recurrent neural network comprises one or more first output layers (220) and one or more second output layers (230), and wherein processing the first recurrent input comprises:
processing the first recurrent input to generate a first half of an updated hidden state; and
processing the first half of the updated hidden state using the one or more first output layers to generate the first score distribution; and
wherein processing the second recurrent input comprises:
processing the second recurrent input to generate a second half of an updated hidden state; and
processing the second half of the updated hidden state using the one or more second output layers to generate the second score distribution.

4. The method of claim 3, wherein the one or more first output layers (220) are configured to:
apply a first weight matrix (**O***₁*) to the first half of the updated hidden state to generate a first projected updated hidden state,
apply an element-wise non-linear activation function to the first projected updated hidden state to generate a first activation vector,
apply a second weight matrix (**O***₂*) to the first activation vector to generate first logits, and
apply a softmax function to the first logits to generate the first score distribution; and
wherein the one or more second output layers (230) are configured to:
apply a third weight matrix (**O***₃*) to the second half of the updated hidden state to generate a second projected updated hidden state,
apply the element-wise non-linear activation function to the second projected updated hidden state to generate a second activation vector,
apply a fourth weight matrix (**O***₄*) to the second activation vector to generate second logits, and
apply the softmax function to the second logits to generate the second score distribution.

5. The method of any one of claims 3-4, wherein the recurrent neural network includes one or more gates (u; r; e), and wherein processing the first recurrent input comprises:
determining a respective recurrent contribution for each gate by applying a recurrent weight matrix **(R)** to the hidden state (***h**ₜ₋₁*); and
for each of the one or more gates:
determining a first input contribution for the gate from the first recurrent input, and
determining a first gate vector for the gate from at least the recurrent contribution for the gate and the first input contribution for the gate; and
generating the first half of the updated hidden state from the first gate vectors and the hidden state.

6. The method of claim 5, wherein processing the second recurrent input comprises:
for each of the one or more gates (u; r; e):
determining a second input contribution for the gate from the second recurrent input, and
determining a second gate vector for the gate from at least the recurrent contribution for the gate and the second input contribution for the gate; and
generating the second half of the updated hidden state from the second gate vectors and the hidden state.

7. The method of claim 6, wherein processing the second recurrent input comprises generating the second half of the updated hidden state without re-computing the recurrent contributions for the gates from the processing of the first recurrent input.

8. The method of any preceding claim, wherein selecting, using the first score distribution, values for the first half of the N bits of the output value comprises sampling the values from the first score distribution, and wherein selecting, using the second score distribution, values for the second half of the N bits of the output value comprises sampling the values from the second score distribution.

9. The method of any preceding claim, further comprising loading parameters of the recurrent neural network into registers of a processing unit only once at the start of generating the output example, wherein the parameters of the recurrent neural network persist in the registers throughout the generating the output example.

10. The method of any preceding claim implemented on the processing unit of a mobile device.

11. The method of any preceding claim implemented on a GPU (Graphics Processing Unit) or other special-purpose neural network hardware.

12. A processing unit (100) configured for generating an output example comprising a respective *N*-bit output value (152) at each generation time step of a sequence of generation time steps, wherein the processing unit is configured to split the generating of the *N*-bit output value into two halves, to generate a first half of the N bits and then a second half of the N bits, wherein the processing unit is configured to, for each generation time step:
process a first recurrent input comprising the *N*-bit output value (112; ***c***_{*t*-1}*,* **f***ₜ₋₁*) at the preceding generation time step in the sequence using a recurrent neural network (110) and in accordance with a hidden state of the recurrent neural network (114; **h***ₜ₋₁*) to generate a first score distribution over possible values for a first half of the *N* bits in the output value at the generation time step;
select, using the first score distribution, values for the first half (116; **c***ₜ*) of the N bits of the output value;
process a second recurrent input comprising (i) the *N*-bit output value (112; ***c***_{*t*-1}*,* **f***ₜ₋₁*) at the preceding generation time step in the sequence and (ii) the values for the first half of the N bits (116; **c***ₜ*) using the recurrent neural network (110) and in accordance with the same hidden state (114; **h***ₜ₋₁*) to generate a second score distribution over possible values for a second half of the N bits in the output value at the generation time step; and
select, using the second score distribution, values for the second half (118; **f***ₜ*) of the N bits of the output value;
wherein the first half of the N bits are the most significant bits and the second half of the N bits are the least significant bits.

13. The processing unit of claim 11, wherein the output value is conditioned on a respective conditioning input (102) at each of the generation time steps, and wherein the first recurrent input and the second recurrent input each also comprise the conditioning input for the generation time step; and wherein the processing unit is further configured to:
generate the conditioning input at the generation time step by processing conditioning features using a conditioning neural network.

14. The processing unit of claim 12 or 13, wherein the processing unit is further configured to load parameters of the recurrent neural network into registers of the processing unit only once at the start of generating the output example, wherein the parameters of the recurrent neural network persist in the registers throughout the generating the output example.

15. One or more computer storage media storing instructions that when executed by one or more computers cause the one or more computers to perform the operations of the respective method of any one of claims 1-11.

## Patentansprüche

1. Computerimplementiertes Verfahren zur Erzeugung eines Ausgabebeispiels, das einen jeweiligen *N*-Bit-Ausgabewert (152) bei jedem Erzeugungszeitschritt einer Sequenz von Erzeugungszeitschritten umfasst, wobei das Verfahren für jeden Erzeugungszeitschritt Folgendes umfasst:
Verarbeiten einer ersten rekurrenten Eingabe, die den *N*-Bit-Ausgabewert (112; **c***ₜ₋₁,* **f***ₜ₋₁)* bei dem vorhergehenden Erzeugungszeitschritt in der Sequenz umfasst, unter Verwendung eines rekurrenten neuronalen Netzwerks (110) und in Übereinstimmung mit einem verborgenen Zustand des rekurrenten neuronalen Netzwerks (114; **h***ₜ₋₁)*, um eine erste Score-Verteilung über mögliche Werte für eine erste Hälfte der *N* Bits in dem Ausgabewert bei dem Erzeugungszeitschritt zu erzeugen;
Auswählen von Werten für die erste Hälfte (116; **c***ₜ*) der N Bits des Ausgabewerts unter Verwendung der ersten Score-Verteilung;
Verarbeiten einer zweiten rekurrenten Eingabe, umfassend (i) den *N*-Bit-Ausgabewert (112; **c***ₜ₋ₗ,* **f***ₜ₋ₗ)* bei dem vorhergehenden Erzeugungszeitschritt in der Sequenz und (ii) die Werte für die erste Hälfte der N Bits (116; **c***ₜ*), unter Verwendung des rekurrenten neuronalen Netzwerks (110) und in Übereinstimmung mit demselben verborgenen Zustand (114; **h***ₜ₋ₗ)*, um eine zweite Score-Verteilung über mögliche Werte für eine zweite Hälfte der *N* Bits in dem Ausgabewert bei dem Erzeugungszeitschritt zu erzeugen; und
Auswählen von Werten für die zweite Hälfte (118; **f***ₜ)* der N Bits des Ausgabewerts unter Verwendung der zweiten Score-Verteilung;
wobei die erste Hälfte der N Bits die höchstwertigen Bits sind und die zweite Hälfte der N Bits die niederwertigsten Bits sind.

2. Verfahren nach Anspruch 1, wobei der Ausgabewert auf eine jeweilige Konditionierungseingabe (102) bei jedem der Erzeugungszeitschritte konditioniert ist, und wobei die erste rekurrente Eingabe und die zweite rekurrente Eingabe jeweils auch die Konditionierungseingabe für den Erzeugungszeitschritt umfassen; wobei das Verfahren ferner umfasst:
Erzeugen der Konditionierungseingabe bei dem Erzeugungszeitschritt durch Verarbeiten von Konditionierungsmerkmalen unter Verwendung eines konditionierenden neuronalen Netzwerks.

3. Verfahren nach einem vorhergehenden Anspruch, wobei das rekurrente neuronale Netzwerk eine oder mehrere erste Ausgabeschichten (220) und eine oder mehrere zweite Ausgabeschichten (230) umfasst, und wobei Verarbeiten der ersten rekurrenten Eingabe Folgendes umfasst:
Verarbeiten der ersten rekurrenten Eingabe, um eine erste Hälfte eines aktualisierten verborgenen Zustands zu erzeugen; und
Verarbeiten der ersten Hälfte des aktualisierten verborgenen Zustands unter Verwendung der einen oder mehreren ersten Ausgabeschichten, um die erste Score-Verteilung zu erzeugen; und
wobei Verarbeiten der zweiten rekurrenten Eingabe Folgendes umfasst:
Verarbeiten der zweiten rekurrenten Eingabe, um eine zweite Hälfte eines aktualisierten verborgenen Zustands zu erzeugen; und
Verarbeiten der zweiten Hälfte des aktualisierten verborgenen Zustands unter Verwendung der einen oder mehreren zweiten Ausgabeschichten, um die zweite Score-Verteilung zu erzeugen.

4. Verfahren nach Anspruch 3, wobei die eine oder mehreren ersten Ausgabeschichten (220) konfiguriert sind zum:
Anwenden einer ersten Gewichtsmatrix (**O***₁*) auf die erste Hälfte des aktualisierten verborgenen Zustands, um einen ersten projizierten aktualisierten verborgenen Zustand zu erzeugen,
Anwenden einer elementweisen nichtlinearen Aktivierungsfunktion auf den ersten projizierten aktualisierten verborgenen Zustand, um einen ersten Aktivierungsvektor zu erzeugen,
Anwenden einer zweiten Gewichtsmatrix (**O***₂*) auf den ersten Aktivierungsvektor, um erste Logits zu erzeugen, und
Anwenden einer Softmax-Funktion auf die ersten Logits, um die erste Score-Verteilung zu erzeugen; und wobei die eine oder mehreren zweiten Ausgabeschichten (230) konfiguriert sind zum:
Anwenden einer dritten Gewichtsmatrix *(***O***₃)* auf die zweite Hälfte des aktualisierten verborgenen Zustands, um einen zweiten projizierten aktualisierten verborgenen Zustand zu erzeugen,
Anwenden der elementweisen nichtlinearen Aktivierungsfunktion auf den zweiten projizierten aktualisierten verborgenen Zustand, um einen zweiten Aktivierungsvektor zu erzeugen,
Anwenden einer vierten Gewichtsmatrix *(***O***₄)* auf den zweiten Aktivierungsvektor, um zweite Logits zu erzeugen, und
Anwenden der Softmax-Funktion auf die zweiten Logits, um die zweite Score-Verteilung zu erzeugen.

5. Verfahren nach einem der Ansprüche 3-4, wobei das rekurrente neuronale Netzwerk ein oder mehrere Gatter (u; r; e) beinhaltet, und wobei Verarbeiten der ersten rekurrenten Eingabe Folgendes umfasst:
Bestimmen eines jeweiligen rekurrenten Beitrags für jedes Gatter durch Anwenden einer rekurrenten Gewichtsmatrix (**R**) auf den verborgenen Zustand *(***h***ₜ₋₁);* und
für jedes des einen oder der mehreren Gatter:
Bestimmen eines ersten Eingabebeitrags für das Gatter aus der ersten rekurrenten Eingabe, und
Bestimmen eines ersten Gattervektors für das Gatter aus zumindest dem rekurrenten Beitrag für das Gatter und dem ersten Eingabebeitrag für das Gatter; und
Erzeugen der ersten Hälfte des aktualisierten verborgenen Zustands aus den ersten Gattervektoren und dem verborgenen Zustand.

6. Verfahren nach Anspruch 5, wobei Verarbeiten der zweiten rekurrenten Eingabe Folgendes umfasst: für jedes des einen oder der mehreren Gatter (u; r; e):
Bestimmen eines zweiten Eingabebeitrags für das Gatter aus der zweiten rekurrenten Eingabe, und
Bestimmen eines zweiten Gattervektors für das Gatter aus zumindest dem rekurrenten Beitrag für das Gatter und dem zweiten Eingabebeitrag für das Gatter; und
Erzeugen der zweiten Hälfte des aktualisierten verborgenen Zustands aus den zweiten Gattervektoren und dem verborgenen Zustand.

7. Verfahren nach Anspruch 6, wobei Verarbeiten der zweiten rekurrenten Eingabe Erzeugen der zweiten Hälfte des aktualisierten verborgenen Zustands ohne Neuberechnen der rekurrenten Beiträge für die Gatter aus der Verarbeitung der ersten rekurrenten Eingabe umfasst.

8. Verfahren nach einem vorhergehenden Anspruch, wobei Auswählen von Werten für die erste Hälfte der N Bits des Ausgabewerts unter Verwendung der ersten Score-Verteilung Abtasten der Werte aus der ersten Score-Verteilung umfasst, und wobei Auswählen von Werten für die zweite Hälfte der N Bits des Ausgabewerts unter Verwendung der zweiten Score-Verteilung Abtasten der Werte aus der zweiten Score-Verteilung umfasst.

9. Verfahren nach einem vorhergehenden Anspruch, ferner umfassend Laden von Parametern des rekurrenten neuronalen Netzwerks in Register einer Verarbeitungseinheit nur einmal zu Beginn der Erzeugung des Ausgabebeispiels, wobei die Parameter des rekurrenten neuronalen Netzwerks in den Registern während der gesamten Erzeugung des Ausgabebeispiels verbleiben.

10. Verfahren nach einem vorhergehenden Anspruch, implementiert auf der Verarbeitungseinheit einer mobilen Vorrichtung.

11. Verfahren nach einem vorhergehenden Anspruch, implementiert auf einer GPU (Graphics Processing Unit) oder anderer Spezialhardware für neuronale Netzwerke.

12. Verarbeitungseinheit (100), die konfiguriert ist zum Erzeugen eines Ausgabebeispiels, das einen jeweiligen *N*-Bit-Ausgabewert (152) bei jedem Erzeugungszeitschritt einer Sequenz von Erzeugungszeitschritten umfasst, wobei die Verarbeitungseinheit konfiguriert ist, die Erzeugung des *N-*Bit-Ausgabewerts in zwei Hälften aufzuteilen, um eine erste Hälfte der N Bits und dann eine zweite Hälfte der N Bits zu erzeugen, wobei die Verarbeitungseinheit konfiguriert ist, um für jeden Erzeugungszeitschritt:
eine erste rekurrente Eingabe, die den *N*-Bit-Ausgabewert (112; **c***ₜ₋ₗ,* **f***ₜ₋ₗ)* bei dem vorhergehenden Erzeugungszeitschritt in der Sequenz umfasst, unter Verwendung eines rekurrenten neuronalen Netzwerks (110) und in Übereinstimmung mit einem verborgenen Zustand des rekurrenten neuronalen Netzwerks (114; **h***ₜ₋ₗ)* zu verarbeiten, um eine erste Score-Verteilung über mögliche Werte für eine erste Hälfte der *N* Bits in dem Ausgabewert bei dem Erzeugungszeitschritt zu erzeugen;
Werte für die erste Hälfte (116; **c***ₜ*) der N Bits des Ausgabewerts unter Verwendung der ersten Score-Verteilung auszuwählen;
eine zweite rekurrente Eingabe, umfassend (i) den *N*-Bit-Ausgabewert (112; **c***ₜ₋ₗ,* **f***ₜ₋ₗ)* bei dem vorhergehenden Erzeugungszeitschritt in der Sequenz und (ii) die Werte für die erste Hälfte der N Bits (116; **c***ₜ*), unter Verwendung des rekurrenten neuronalen Netzwerks (110) und in Übereinstimmung mit demselben verborgenen Zustand (114; **h***ₜ₋ₗ)* zu verarbeiten, um eine zweite Score-Verteilung über mögliche Werte für eine zweite Hälfte der *N* Bits in dem Ausgabewert bei dem Erzeugungszeitschritt zu erzeugen; und
Werte für die zweite Hälfte (118; **f***ₜ)* der N Bits des Ausgabewerts unter Verwendung der zweiten Score-Verteilung auszuwählen;
wobei die erste Hälfte der N Bits die höchstwertigen Bits sind und die zweite Hälfte der N Bits die niederwertigsten Bits sind.

13. Verarbeitungseinheit nach Anspruch 11, wobei der Ausgabewert auf eine jeweilige Konditionierungseingabe (102) bei jedem der Erzeugungszeitschritte konditioniert ist, und wobei die erste rekurrente Eingabe und die zweite rekurrente Eingabe jeweils auch die Konditionierungseingabe für den Erzeugungszeitschritt umfassen; und wobei die Verarbeitungseinheit ferner konfiguriert ist zum:
Erzeugen der Konditionierungseingabe bei dem Erzeugungszeitschritt durch Verarbeiten von Konditionierungsmerkmalen unter Verwendung eines konditionierenden neuronalen Netzwerks.

14. Verarbeitungseinheit nach Anspruch 12 oder 13, wobei die Verarbeitungseinheit ferner konfiguriert ist, Parameter des rekurrenten neuronalen Netzwerks in Register der Verarbeitungseinheit nur einmal zu Beginn der Erzeugung des Ausgabebeispiels zu laden, wobei die Parameter des rekurrenten neuronalen Netzwerks in den Registern während der gesamten Erzeugung des Ausgabebeispiels verbleiben.

15. Ein oder mehrere Computerspeichermedien, die Anweisungen speichern, die, wenn sie von einem oder mehreren Computern ausgeführt werden, den einen oder die mehreren Computer veranlassen, die Operationen des jeweiligen Verfahrens nach einem der Ansprüche 1-11 durchzuführen.

## Revendications

1. Procédé mis en œuvre par ordinateur pour générer un exemple de sortie comprenant une valeur de sortie respective de *N* bits (152) à chaque étape temporelle de génération d'une séquence d'étapes temporelles de génération, le procédé comprenant, pour chaque étape temporelle de génération :
le traitement d'une première entrée récurrente comprenant la valeur de sortie de *N* bits (112 ; **c***ₜ₋₁,* **f***ₜ₋₁)* à l'étape temporelle de génération précédente dans la séquence au moyen d'un réseau neuronal récurrent (110) et conformément à un état caché du réseau neuronal récurrent (114 ; **h***ₜ₋₁)* afin de générer une première distribution de scores sur des valeurs possibles pour une première moitié des *N* bits dans la valeur de sortie à l'étape temporelle de génération ;
la sélection, au moyen de la première distribution de scores, de valeurs pour la première moitié (116 ; **c***ₜ*) des N bits de la valeur de sortie ;
le traitement d'une seconde entrée récurrente comprenant (i) la valeur de sortie de *N* bits (112 ; **c***ₜ₋₁,* **f***ₜ₋₁)* à l'étape temporelle de génération précédente dans la séquence et (ii) les valeurs pour la première moitié des N bits (116 ; **c***ₜ*) au moyen du réseau neuronal récurrent (110) et conformément au même état caché (114 ; **h***ₜ₋₁)* afin de générer une seconde distribution de scores sur des valeurs possibles pour une seconde moitié des *N* bits dans la valeur de sortie à l'étape temporelle de génération ; et
la sélection, au moyen de la seconde distribution de scores, de valeurs pour la seconde moitié (118 ; **f***ₜ)* des N bits de la valeur de sortie ;
dans lequel la première moitié des N bits sont les bits les plus significatifs et la seconde moitié des N bits sont les bits les moins significatifs.

2. Procédé selon la revendication 1, dans lequel la valeur de sortie est conditionnée par une entrée de conditionnement respective (102) à chacune des étapes temporelles de génération, et dans lequel la première entrée récurrente et la seconde entrée récurrente comprennent chacune également l'entrée de conditionnement pour l'étape temporelle de génération ; le procédé comprenant en outre :
la génération de l'entrée de conditionnement à l'étape temporelle de génération par le traitement de caractéristiques de conditionnement au moyen d'un réseau neuronal de conditionnement.

3. Procédé selon l'une quelconque revendication précédente, dans lequel le réseau neuronal récurrent comprend une ou plusieurs premières couches de sortie (220) et une ou plusieurs secondes couches de sortie (230), et dans lequel le traitement de la première entrée récurrente comprend :
le traitement de la première entrée récurrente afin de générer une première moitié d'un état caché mis à jour ; et
le traitement de la première moitié de l'état caché mis à jour au moyen de la ou des premières couches de sortie afin de générer la première distribution de scores ; et
dans lequel le traitement de la seconde entrée récurrente comprend :
le traitement de la seconde entrée récurrente afin de générer une seconde moitié d'un état caché mis à jour ; et
le traitement de la seconde moitié de l'état caché mis à jour au moyen de la ou des secondes couches de sortie afin de générer la seconde distribution de scores.

4. Procédé selon la revendication 3, dans lequel la ou les premières couches de sortie (220) sont configurées pour :
appliquer une première matrice de pondération (**O***₁*) à la première moitié de l'état caché mis à jour afin de générer un premier état caché mis à jour projeté,
appliquer une fonction d'activation non linéaire élément par élément au premier état caché mis à jour projeté afin de générer un premier vecteur d'activation,
appliquer une deuxième matrice de pondération (**O***₂*) au premier vecteur d'activation afin de générer des premiers logits, et
appliquer une fonction softmax aux premiers logits afin de générer la première distribution de scores ; et
dans lequel la ou les secondes couches de sortie (230) sont configurées pour :
appliquer une troisième matrice de pondération *(***O***₃)* à la seconde moitié de l'état caché mis à jour afin de générer un second état caché mis à jour projeté,
appliquer la fonction d'activation non linéaire élément par élément au second état caché mis à jour projeté afin de générer un second vecteur d'activation,
appliquer une quatrième matrice de pondération *(***O***₄)* au second vecteur d'activation afin de générer des seconds logits, et
appliquer la fonction softmax aux seconds logits afin de générer la seconde distribution de scores.

5. Procédé selon l'une quelconque des revendications 3 et 4, dans lequel le réseau neuronal récurrent comporte une ou plusieurs portes (u ; r ; e), et dans lequel le traitement de la première entrée récurrente comprend :
la détermination d'une contribution récurrente respective pour chaque porte par application d'une matrice de pondération récurrente (**R**) à l'état caché (**h***ₜ₋₁*) ; et
pour chacune de la ou des portes :
la détermination d'une première contribution d'entrée pour la porte à partir de la première entrée récurrente, et
la détermination d'un premier vecteur de porte pour la porte à partir au moins de la contribution récurrente pour la porte et de la première contribution d'entrée pour la porte ; et
la génération de la première moitié de l'état caché mis à jour à partir des premiers vecteurs de porte et de l'état caché.

6. Procédé selon la revendication 5, dans lequel le traitement de la seconde entrée récurrente comprend : pour chacune de la ou des portes (u ; r ; e) :
la détermination d'une seconde contribution d'entrée pour la porte à partir de la seconde entrée récurrente, et
la détermination d'un second vecteur de porte pour la porte à partir au moins de la contribution récurrente pour la porte et de la seconde contribution d'entrée pour la porte ; et
la génération de la seconde moitié de l'état caché mis à jour à partir des seconds vecteurs de porte et de l'état caché.

7. Procédé selon la revendication 6, dans lequel le traitement de la seconde entrée récurrente comprend la génération de la seconde moitié de l'état caché mis à jour sans recalculer les contributions récurrentes pour les portes issues du traitement de la première entrée récurrente.

8. Procédé selon l'une quelconque revendication précédente, dans lequel la sélection, au moyen de la première distribution de scores, de valeurs pour la première moitié des N bits de la valeur de sortie comprend l'échantillonnage des valeurs à partir de la première distribution de scores, et dans lequel la sélection, au moyen de la seconde distribution de scores, de valeurs pour la seconde moitié des N bits de la valeur de sortie comprend l'échantillonnage des valeurs à partir de la seconde distribution de scores.

9. Procédé selon l'une quelconque revendication précédente, comprenant en outre le chargement de paramètres du réseau neuronal récurrent dans des registres d'une unité de traitement une seule fois au début de la génération de l'exemple de sortie, dans lequel les paramètres du réseau neuronal récurrent persistent dans les registres tout au long de la génération de l'exemple de sortie.

10. Procédé selon l'une quelconque revendication précédente mis en œuvre sur l'unité de traitement d'un dispositif mobile.

11. Procédé selon l'une quelconque revendication précédente mis en œuvre sur une unité de traitement graphique (GPU) ou un autre matériel de réseau neuronal dédié.

12. Unité de traitement (100) configurée pour générer un exemple de sortie comprenant une valeur de sortie respective de *N* bits (152) à chaque étape temporelle de génération d'une séquence d'étapes temporelles de génération, dans laquelle l'unité de traitement est configurée pour diviser la génération de la valeur de sortie de *N* bits en deux moitiés, pour générer une première moitié des N bits puis une seconde moitié des N bits, dans laquelle l'unité de traitement est configurée pour, pour chaque étape temporelle de génération :
traiter une première entrée récurrente comprenant la valeur de sortie de *N* bits (112 ; **c***ₜ₋₁,* **f***ₜ₋₁)* à l'étape temporelle de génération précédente dans la séquence au moyen d'un réseau neuronal récurrent (110) et conformément à un état caché du réseau neuronal récurrent (114 ; **h***ₜ₋₁)* afin de générer une première distribution de scores sur des valeurs possibles pour une première moitié des *N* bits dans la valeur de sortie à l'étape temporelle de génération ;
sélectionner, au moyen de la première distribution de scores, des valeurs pour la première moitié (116 ; **c***ₜ*) des N bits de la valeur de sortie ;
traiter une seconde entrée récurrente comprenant (i) la valeur de sortie de *N* bits (112 ; **c***ₜ₋₁,* **f***ₜ₋₁)* à l'étape temporelle de génération précédente dans la séquence et (ii) les valeurs pour la première moitié des N bits (116 ; **c***ₜ*) au moyen du réseau neuronal récurrent (110) et conformément au même état caché (114 ; **h***ₜ₋₁)* afin de générer une seconde distribution de scores sur des valeurs possibles pour une seconde moitié des *N* bits dans la valeur de sortie à l'étape temporelle de génération ; et
sélectionner, au moyen de la seconde distribution de scores, des valeurs pour la seconde moitié (118 ; **f***ₜ)* des N bits de la valeur de sortie ;
dans laquelle la première moitié des N bits sont les bits les plus significatifs et la seconde moitié des N bits sont les bits les moins significatifs.

13. Unité de traitement selon la revendication 11, dans laquelle la valeur de sortie est conditionnée par une entrée de conditionnement respective (102) à chacune des étapes temporelles de génération, et dans laquelle la première entrée récurrente et la seconde entrée récurrente comprennent chacune également l'entrée de conditionnement pour l'étape temporelle de génération ; et dans laquelle l'unité de traitement est en outre configurée pour :
générer l'entrée de conditionnement à l'étape temporelle de génération par le traitement de caractéristiques de conditionnement au moyen d'un réseau neuronal de conditionnement.

14. Unité de traitement selon la revendication 12 ou 13, dans laquelle l'unité de traitement est en outre configurée pour charger des paramètres du réseau neuronal récurrent dans des registres de l'unité de traitement une seule fois au début de la génération de l'exemple de sortie, dans laquelle les paramètres du réseau neuronal récurrent persistent dans les registres tout au long de la génération de l'exemple de sortie.

15. Un ou plusieurs supports de stockage informatique stockant des instructions qui, lorsqu'elles sont exécutées par un ou plusieurs ordinateurs, amènent le ou les ordinateurs à réaliser les opérations du procédé respectif selon l'une quelconque des revendications 1 à 11.
